Europäisches Patentamt

European Patent Office

Office européen des brevets

(19)

(11) Veröffentlichungsnummer: **0 213 584 B1**

(12) ## EUROPÄISCHE PATENTSCHRIFT

(45) Veröffentlichungstag der Patentschrift: **02.12.92**

(51) Int. Cl.5: **H03K 5/13**

(21) Anmeldenummer: **86111735.6**

(22) Anmeldetag: **25.08.86**

(54) **Schaltungsanordnung mit einer matrixförmigen Speicheranordnung zur variabel einstellbaren Verzögerung digitaler Signale.**

(30) Priorität: **04.09.85 DE 3531613**

(43) Veröffentlichungstag der Anmeldung:
**11.03.87 Patentblatt 87/11**

(45) Bekanntmachung des Hinweises auf die
Patenterteilung:
**02.12.92 Patentblatt 92/49**

(84) Benannte Vertragsstaaten:
**AT BE CH DE FR GB IT LI NL SE**

(56) Entgegenhaltungen:
**EP-A- 0 031 950        EP-A- 0 193 197**
**EP-A- 0 217 122        DE-A- 3 501 310**
**US-A- 3 893 088        US-A- 4 426 685**

**IBM TECHNICAL DISCLOSURE BULLETIN,
Band 25, Nr. 9, Februar 1983, Seiten
4858-4859, New York, US; W.B. CHIN et al.:
"Static latch with inverted output device"**

**PATENT ABSTRACTS OF JAPAN, Band 8, Nr.
70 (E-235)[1507], 3. April 1984; & JP-A-58 218
229 (FUJITSU K.K.) 19-12-1983**

**IEEE TRANSACTIONS ON MAGNETICS, Band
SC19, Nr. 6, Dezember 1984, Seiten 999-1007,**

**IEEE, New York, US; R. PINKHAM et al.: "A
high speed dual port memory with simultaneous serial and random mode access for
video applications"**

(73) Patentinhaber: **SIEMENS AKTIENGESELL-
SCHAFT
Wittelsbacherplatz 2
W-8000 München 2(DE)**

(72) Erfinder: **Mattausch, Hans Jürgen, Dr.
Am Brunnen 25
W-8011 Kirchheim(DE)**

EP 0 213 584 B1

## Beschreibung

Die vorliegende Erfindung bezieht sich auf eine Schaltungsanordnung mit einer matrixförmigen Speicheranordnung zur variabel einstellbaren Verzögerung digitaler Signale
wobei die Speicheranordnung einen Dateneingang aufweist, über den die zu verzögernden digitalen Signale eingebbar sind,
wobei ein von einem Eingangsdatentakt taktgesteuerter, kontinuierlich fortschaltbarer, jederzeit rücksetzbarer Zeilenwähler vorgesehen ist, der je zwei in der Phase gegeneinander versetzte Signalausgänge je Wählschritt aufweist, die jeweils eine Schreibwortleitung bzw. eine Lesewortleitung ansteuern, welche je Zeile der Matrix vorgesehen sind,
wobei je Spalte zwei getrennte Bitleitungen, nämlich eine Schreibbitleitung und eine Lesebitleitung, vorgesehen sind, die jeweils mit allen Speicherzellen einer Spalte zusammengeschaltet sind und
wobei je Spalte ein abtrennbarer, speichernder Verstärker vorgesehen ist, dessen Eingang mit der Lesebitleitung der ihm zugeordneten Spalte und dessen Ausgang mit der Schreibbitleitung der ihm nachgeordneten Spalte verbunden ist und als ein ihm zugeordneter Datenausgang dient.

Auf dem Gebiet der digitalen Signalverarbeitung sowie auf dem Gebiet der Nachrichtentechnik werden vielfach Einrichtungen benötigt, mit deren Hilfe definierte Verzögerungen von digitalen Datenströmen bewirkt werden können. Definierte Verzögerungen werden beispielsweise zum Ausgleich von Lochzeiten verwendet. Bei einer konstanten Anzahl von gewünschten Verzögerungstakten bietet sich im allgemeinen als Verzögerungseinrichtung eine Anordnung mit einem Schieberegister an. Soll jedoch die Verzögerung variabel einstellbar sein, so ergeben sich bei Verwendung von Schieberegistern bestimmte Probleme.

Es ist auch bekannt, Datenströme definiert mittels einer Anordnung aus Standardschaltungen und Speicherbausteinen verzögern. In einer derartigen Anordnung werden die Bestandteile des Datenstromes in einem frei adressierbaren Speicher abgelegt. Dieser Speicher wird durch einen Decoder angesteuert, der seinerseits durch einen (oder mehrere) Zähler angesteuert wird. Dabei wird die Dauer der Verzögerung durch den Abstand der Zähler-Rücksetzimpulse gegeben. Da die Speicherzellen derartiger frei adressierbarer Speicher je Takt nur jeweils lesen oder schreiben können, ergibt sich dabei die Notwendigkeit, entweder die Speicher mit der doppelten Taktrate zu betreiben oder zwischen zwei Speichereinheiten in einem Multiplex-Betrieb hin- und herzuschalten. Die erste Lösung dieses Problems hat den Nachteil, daß die maximale Datentaktfrequenz nur halb so groß wie die maximale Speicherzyklusfrequenz sein darf. Die Lösung des letzteren Problems erfordert aufwendige Logikschaltungen zur Adressteuerung und einer erforderlichen Umordnung der Daten. Für eine integrierbare Realisierung einer derartigen Schaltungsanordnung entstehen außerdem Nachteile wegen des hohen Platzbedarfs der notwendigen Multiplexer und wegen der erforderlichen umfangreichen Verdrahtung.

Aus der Druckschrift US-A-3 893 088 ist eine Schaltungsanordnung mit einer matrixförmigen Speicheranordnung zur variabel einstellbaren Verzögerung digitaler Signale bekannt, wobei ein vom Eingangsdatentakt taktgesteuerter, kontinuierlich fortschaltbarer Zeilenwähler vorgesehen ist, der je zwei in der Phase gegeneinander versetzte Signalausgänge je Wählschritt aufweist, die jeweils eine der Schreibwortleitungen bzw. der Lesewortleitungen ansteuern, welche je Zeile der Matrix vorgesehen sind, wobei je Spalte zwei getrennte Bitleitungen, nämlich eine der Schreibbitleitungen und eine der Lesebitleitungen vorgesehen sind, die jeweils mit allen Speicherzellen einer Spalte zusammengeschaltet sind, wobei je Spalte ein abtrennbarer, speichernder Verstärker vorgesehen sein kann, dessen Eingang mit der Lesebitleitung der ihm zugeordneten Spalte und dessen Ausgang mit der Schreibbitleitung der ihm nachgeordneten Spalte verbunden ist, und wobei die Speicheranordnung einen Dateneingang aufweist, über den die zu verzögernden Datensignale eingebbar sind.

Aus der Druckschrift EP-A-0 031 950 ist eine Anregung zu einer Auswahleinrichtung entnehmbar, durch die die Länge einer Schieberegisterstrecke verändert wird, was bei einer matrixförmigen Speicheranordnung der Auswahl der Spalte für das Ausgangssignal entspricht.

In der zeitrang gleichen EP-A-0 217 122 (Priorität vom 4.9.1985) wird ebenfalls eine Schaltungsanordnung mit einer matrixförmigen Speicheranordnung zur variablen einstellbaren Verzögerung digitaler Signale beschrieben.

In der älteren europäischen Patentanmeldung EP-A-0 193 157 ist bereits eine Schaltungsanordnung vorgeschlagen worden, mittels derer definierte, variabel einstellbare Verzögerungszeiten erzielt werden können, die durch eine integrierte Schaltungsanordnung realisierbar ist, die einen geringen Flächenbedarf benötigt und eine hohe Datenrate zuläßt. Diese Schaltungsanordnung ist für die Integration in MOS-Technik besonders geeignet. Die EP-A-0 193 157 ist ein Stand der Technik gemäß Artikel 54 (3) EPÜ nach Maßgabe des Artikels 54 (4) EPÜ.

Die der Erfindung zugrundeliegende Aufgabe besteht darin, eine Schaltungsanordnung mit einer matrixförmigen Speicheranordnung zur variabel einstellbaren Verzögerung digitaler Signale anzugeben, die gegenüber dem Stand der Technik hinsichtlich der Variationsmöglichkeit der Verzögerungszeit und hinsichtlich des schaltungstechnischen Aufwandes weiter verbessert ist.

Diese Aufgabe wird bei einer Schaltungsanordnung der eingangs angegebenen Art gemäß den Merkmalen des Patentanspruchs 1 gelöst.

Vorteilhafte Weiterbildungen der Erfindung sind durch die in den Unteransprüchen angegebenen Merkmalen gekennzeichnet.

Im folgenden wird die Erfindung anhand zweier Figuren weiter erläutert.

Figur 1 zeigt ein Ausführungsbeispiel der bereits in der EP-A-0 193 157 vorgeschlagenen Schaltungsanordnung, auf welche Schaltungsanordnung die Schaltungsanordnung gemäß der vorliegenden Erfindung anwendbar ist und die in der vorliegenden Patentanmeldung als Speicheranordnung SP bezeichnet ist.

Fig. 2 zeigt ein Prinzipschaltbild der erfindungsgemäßen Schaltungsanordnung, in der die Speicheranordnung SP gemäß Fig. 1 enthalten ist.

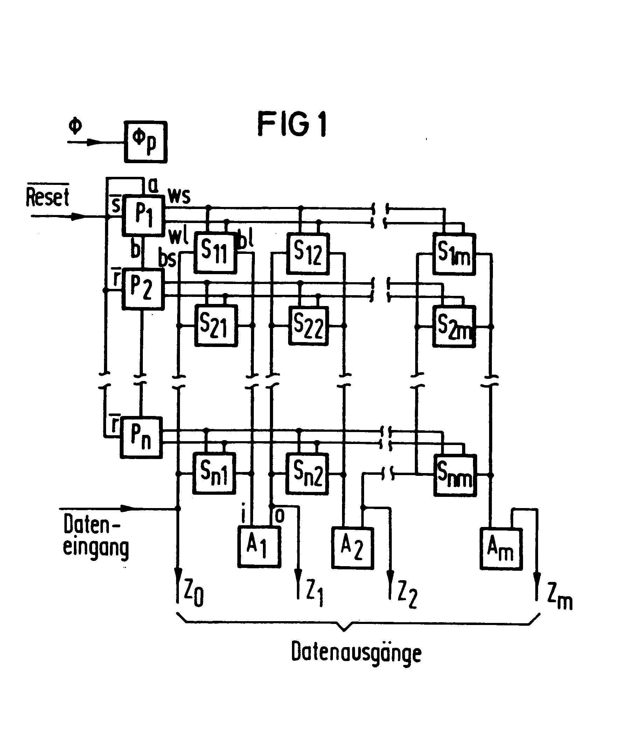

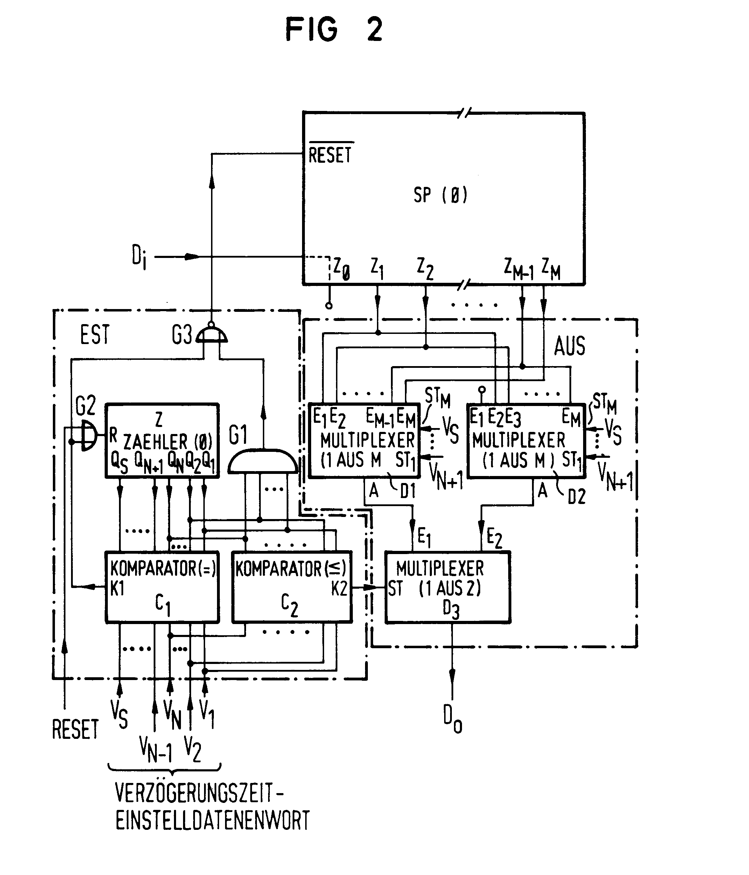

Wie Fig. 1 zeigt, ist eine Auswahleinrichtung AUS zum Auswählen von Spalten der Speicherordnung SP vorgesehen, die zwischen zwei ausgewählten benachbarten Spalten umschaltbar ist und der ein Teil eines externen Verzögerungszeit-Einstelldatenwortes zur Auswahl dieser Spalten zuführbar ist. Zum Umschalten zwischen den beiden benachbarten Spalten ist eine dynamische Umschaltung mittels eines zugeführten Steuersignals ST zu der Auswahleinrichtung AUS vorgesehen. Außerdem ist, wie aus Fig. 2 ersichtlich, eine Einstell- und Steuereinrichtung EST vorgesehen, der das gesamte externe Verzögerungszeit-Einstelldatenwort zugeführt wird. Diese Einstell- und Steuereinrichtung EST erzeugt ein Rückstellsignal $\overline{RESET}$ für die Speicheranorndung SP und das Steuersignal ST für die Auswahleinrichtung AUS. Der Einstell- und Steuereinrichtung EST wird ein externes Rücksetzsignal RESET über einen Rücksetzeingang zugeführt. Dieses Rücksetzsignal wird dazu benutzt, die Einstell- und Steuereinrichtung EST unmittelbar und die Speicheranordnung SP mittelbar rückzustellen. Die Speicheranorndung SP weist einen Dateneingang $D_i$ auf, über den die zu verzögernden Datensignale eingebbar sind. Die Auswahleinrichtung AUS weist einen Datenausgang $D_0$ auf, über den die verzögerten Datensignale ausgebbar sind. Die Auswahleinrichtung AUS ist mit Dateneingängen $E_1...E_m$ mit Datenausgängen $Z_1...Z_M$ der Speicheranordnung SP verbunden. Die Einstell- und Steuereinrichtung EST ist datentaktgesteuert.

Die Auswahleinrichtung AUS besteht aus einer Anordnung aus einem ersten Multiplexer $D_1$, einem zweiten Multiplexer $D_2$ und einem dritten Multiplexer $D_3$, wobei Datenausgänge $Z_1...Z_M$ der Speicheranordnung SP jeweils mit Dateneingängen $E_1...E_M$ des ersten Multiplexers $D_1$ und mit Dateneingängen $E_2...E_M$ des zweiten Multiplexers $D_2$ unter Versatz um eine Stelle verbunden sind, wobei der letzte Datenausgang $Z_M$ der Speicheranordnung SP nicht mit einem der Dateneingänge des zweiten Multiplexers $D_2$ verbunden ist und wobei der erste Dateneingang $E_1$ dieses zweiten Multiplexers $D_2$ frei bleibt. Für beide Multiplexer $D_1$, $D_2$ sind jeweils Wähleingänge $ST_1...ST_M$ vorgesehen, die mit einem bestimmten Teil des externen Verzögerungszeit-Einstelldatenwortes beaufschlagt werden und mittels derer in den Multiplexern $D_1$, $D_2$ jeweils deren Ausgang A mit einem der Dateneingänge, z. B. $E_2$, in dem ersten Multiplexer $D_1$ bzw. $E_2$ in dem zweiten Multiplexer $D_2$ verbindbar ist. Die beiden Ausgänge A,A der Multiplexer $D_1$, $D_2$ sind mit den beiden einzigen Dateneingängen $E_1$, $E_2$ des dritten Multiplexers $D_3$ verbunden, dessen Ausgang A den Datenausgang $D_o$ für die verzögerten Eingangsdaten darstellt und der einen einzigen Steuereingang ST aufweist.

Die Einstell- und Steuereinrichtung EST enthält einen Zähler Z, einen ersten Komparator $C_1$, einen zweiten Komparator $C_2$, ein UND-Glied $G_1$, ein ODER-Glied $G_2$ und eine NOR-Glied $G_3$. Der Zähler Z weist eine Anzahl von Zählschritten auf, die der Anzahl der Speicherplätze der Speicherordnung SP entspricht. Der erste Komparator $C_1$ weist die Funktion "=" auf. Der zweite Komparator $C_2$ weist die Funktion "≦" auf. Die Einstell- und Steuereinrichtung EST hat eine Vielzahl von Einstelleingängen $V_1$, $V_2...V_N$, $V_{N+1}...V_S$ zum Anlegen des externen Verzögerungszeit-Einstelldatenwortes und einen Rücksetzeingang RESET, wobei die Einstelleingänge in eine erste Gruppe für die niederwertigen Bits des Verzögerungszeit-Einstelldatenwortes mit den Einstelleingängen $V_1...V_N$ und in eine zweite Gruppe für die höherwertigen Bits mit den Einstelleingängen $V_{N+1}...V_S$ unterteilt sind.

Mittels der Einstelleingänge $V_1...V_N$ der ersten Gruppe wird eine beliebige Zeile der Speicherordnung SP in codierter Form gekennzeichnet. Diese Kennzeichnung dient als ein erster Vergleichswert für den zweiten Komparator $C_2$. Mittels der Einstelleingänge sowohl der ersten als auch der zweiten Gruppe wird die betreffende Zeile bzw. eine beliebige Spalte in codierter Form gekennzeichnet. Diese Kennzeichnungen dienen insgesamt als erster Vergleichswert für den ersten Komparator $C_1$. Der erste Komparator $C_1$ hat eine Vielzahl von Vergleichswerteingängen entsprechend Datenausgängen $Q_1...Q_N$, $Q_{N+1}...Q_S$ des Zählers Z, denen ein dem jeweiligen Zählstand des Zählers Z entsprechendes Zählstandsdatenwort zugeführt wird. Der zweite Komparator $C_2$ hat eine Anzahl von Vergleichswerteingängen entsprechend den Datenausgängen $Q_1...Q_N$ einer ersten Gruppe der Datenausgänge des Zählers Z, denen die niederwertigen Bits des dem jeweiligen Zählstand entsprechenden Zählstandsdatenwortes zugeführt werden. Dem UND-Glied $G_1$ werden gleichfalls diese zuletzt genannten Bits über entsprechend viele Eingänge zugeführt. Der erste Komparator $C_1$ hat einen Vergleichsausgang $K_1$, der mit einem von zwei Eingängen des ODERGliedes $G_2$ und einem von zwei Engängen des NOR-Gliedes $G_3$ verbunden ist und ein Ausgangssignal gemäß der Bedingung

$$K_1 = \{Q_1 \dots Q_S\} = \{V_1 \dots V_S\}$$

abgibt. Der zweite Eingang des ODER-Gliedes $G_2$ ist mit dem Rücksetzeingang der Einstell- und Steuereinrichtung EST verbunden. Der zweite Eingang des NOR-Gliedes $G_3$ ist mit dem Ausgang des UND-Gliedes $G_1$ verbunden. Der Rücksetzeingang der Speicheranordnung SP wird mit dem Ausgangssignal des NOR-Gliedes $G_3$ beaufschlagt. Ein Rücksetzeingang R des Zählers Z wird mit dem Ausgangssignal des ODER-Gliedes $G_2$ beaufschlagt. Ein Vergleichsausgang $K_2$ des zweiten Komparators $C_2$ ist mit dem Steuereingang ST des dritten Multiplexers $D_3$ verbunden. Der zweite Komparator $C_2$ gibt ein Ausgangssignal an den Vergleichsausgang $K_2$ gemäß der Bedingung

$$K_2 = \{Q_1 \dots Q_N\} \leqq \{V_1 \dots V_N\}$$

ab, in welchem Fall der erste Dateneingang $E_1$ des dritten Multiplexers $D_3$ mit dessen Datenausgang $D_0$ verbunden ist.

Entsprechend der Wortbreite der Eingangsdaten kann gemäß einer Weiterbildung der vorliegenden Erfindung die Zahl von matrixförmigen Speicheranordnungen SP vorgesehen sein, deren Schreibwort- bzw. Lesewortleitungen paralell geschaltet und mit dem gemeinsam für diese matrixförmigen Speicheranordnungen SP vorgesehenen Zeilenwähler verbunden sind (nicht dargestellt).

**Patentansprüche**

1. Schaltungsanordnung mit einer matrixförmigen Speicheranordnung (SP) zur variabel einstellbaren Verzögerung digitaler Signale,
   wobei die Speicheranordnung (SP) einen Dateneingang (Di) aufweist, über den die zu verzögernden digitalen Signale eingebbar sind,
   wobei ein von einem Eingangsdatentakt taktgesteuerter, kontinuierlich fortschaltbarer, jederzeit rücksetzbarer Zeilenwähler ($P_1 \dots P_N$) vorgesehen ist, der je zwei in der Phase gegeneinander versetzte Signalausgänge je Wählschritt aufweist, die jeweils eine Schreibwortleitung bzw. eine Lesewortleitung ansteuern, welche je Zeile der Matrix vorgesehen sind,
wobei je Spalte zwei getrennte Bitleitungen, nämlich eine Schreibbitleitung und eine Lesebitleitung, vorgesehen sind, die jeweils mit allen Speicherzellen einer Spalte zusammengeschaltet sind,
wobei je Spalte ein abtrennbarer, speichernder Verstärker ($A_1 \dots A_m$) vorgesehen ist, dessen Eingang mit der Lesebitleitung der ihm zugeordneten Spalte und dessen Ausgang mit der Schreibbitleitung der ihm nachgeordneten Spalte verbunden ist und als ein ihm zugeordneter Datenausgang dient,

- wobei der Dateneingang der matrixförmigen Speicheranordnung (SP) für die zu verzögernden Datensignale mit der Schreibbitleitung der ersten Spalte und einem unverzögerten Datenausgang ($Z_{\emptyset}$) verbunden ist,
- wobei ein Rücksetzeingang mit Setzeingängen eines ersten Gliedes ($P_1$) des Zeilenwählers sowie mit den Rücksetzeingängen der restlichen Glieder ($P_2 \dots P_N$) des Zeilenwählers verbunden ist,
- wobei eine Auswahleinrichtung (AUS) zum Auswählen von Spalten der Speicheranordnung (SP) vorgesehen ist, die zwischen zwei ausgewählten benachbarten Spalten umschaltbar ist und der ein Teil eines externen Verzögerungszeit-Einstelldatenwortes zur Auswahl dieser Spalten zuführbar ist,
- wobei zum Umschalten zwischen den beiden benachbarten Spalten eine dynamische Umschaltung mittels eines zugeführten Steuersignals (ST) vorgesehen ist,
- wobei eine Einstell- und Steuereinrichtung (EST) vorgesehen ist, der das gesamte externe Verzögerungszeit-Einstelldatenwort zugeführt wird, die ein Rückstellsignal ($\overline{\text{RESET}}$) für die Speicheranordnung (SP) und das Steuersignal (ST) für die Auswahleinrichtung (AUS) erzeugt und der ein externes Rücksetzsignal (RESET) über einen Rücksetzeingang zugeführt wird, welches dazu benutzt wird, die Einstell- und Steuereinrichtung (EST) unmittelbar und die Speicheranordnung (SP) mittelbar rückzustellen,
- wobei die Auswahleinrichtung (AUS) einen Datenausgang ($D_0$) aufweist, über den die verzögerten Datensignale ausgebbar sind,
- wobei die Auswahleinrichtung (AUS) mit Dateneingängen ($E_1 \dots E_M$) mit Datenausgängen ($Z_1 \dots Z_M$) der Speicheranordnung (SP) verbunden ist,

- wobei die Einstell- und Steuereinrichtung (EST) datentaktgesteuert ist und

- wobei als speichernde Elemente 3-Transistorzellen mit überlappenden Schreib-/Lesezyklen vorgesehen sind.

2. Schaltungsanordnung nach Anspruch 1, dadurch **gekennzeichnet,**

- daß die Auswahleinrichtung (AUS) aus einer Anordnung aus einem ersten Multiplexer ($D_1$), einem zweiten Multiplexer ($D_2$) und einem dritten Multiplexer ($D_3$) besteht, wobei Datenausgänge ($Z_1 ... Z_M$) der Speicheranordnung (SP) jeweils mit Dateneingängen ($E_1...E_M$) des ersten Multiplexers ($D_1$) und mit Dateneingängen ($E_2 ... E_M$) des zweiten Multiplexers ($D_2$) unter Versatz um eine Stelle verbunden sind, wobei der letzte Datenausgang ($Z_M$) der Speicheranordnung (SP) nicht mit einem der Dateneingänge des zweiten Multiplexers ($D_2$) verbunden ist und wobei der erste Dateneingang ($E_1$) dieses zweiten Multiplexers ($D_2$) frei bleibt,

- daß für beide Multiplexer ($D_1$, $D_2$) jeweils Wähleingänge ($ST_1...ST_M$) vorgesehen sind, die mit dem genannten Teil des externen Verzögerungszeit-Einstelldatenwortes beaufschlagt werden und mittels derer in den Multiplexern ($D_1$, $D_2$) jeweils deren Ausgang (A) mit einem der Dateneingänge (z.B. $E_2$) in dem ersten Multiplexer ($D_1$) bzw. ($E_2$) in dem zweiten Multiplexer ($D_2$) verbindbar ist,

- daß die beiden Ausgänge (A, A) der Multiplexer ($D_1$, $D_2$) mit den beiden einzigen Dateneingängen ($E_1$, $E_2$) des dritten Multiplexers ($D_3$) verbunden sind, dessen Ausgang (A) den Datenausgang ($D_o$) für die verzögerten Eingangsdaten darstellt und der einen einzigen Steuereingang (ST) aufweist,

- daß die Einstell- und Steuereinrichtung (EST) einen Zähler (Z), einen ersten Komparator ($C_1$), einen zweiten Komparator ($C_2$), ein UND-Glied ($G_1$), ein ODER-Glied ($G_2$) und ein NOR-Glied ($G_3$) enthält,

- daß der Zähler (Z) eine Anzahl von Zählschritten aufweist, die der Anzahl der Speicherplätze der Speicheranordnung (SP) entspricht,

- daß der erste Komparator ($C_1$) die Funktion " = " aufweist,

- daß der zweite Komparator ($C_2$) die Funktion "$\leq$" aufweist,

- daß die Einstell- und Steuereinrichtung (EST) eine Vielzahl von Einstelleingängen ($V_1$, $V_2$ ... $V_N$, $V_{N+1}...V_S$) zum Anlegen des externen Verzögerungszeit-Einstelldatenwortes und einen Rücksetzeingang (RESET) hat, wobei die Einstelleingänge in eine erste Gruppe für die niederwertigen Bits des Verzögerungszeit-Einstelldatenwortes mit den Einstelleingängen ($V_1...V_N$) und in eine zweite Gruppe für die höherwertigen Bits mit den Einstelleingängen ($V_{N+1}...V_S$) unterteilt sind,

- daß mittels der Einstelleingänge ($V_1...V_N$) der ersten Gruppe eine beliebige Zeile der Speicheranordnung (SP) in codierter Form gekennzeichnet wird, welche Kennzeichnung als ein erster Vergleichswert für den zweiten Komparator ($C_2$) dient, und mittels der Einstelleingänge sowohl der ersten als auch der zweiten Gruppe die betreffende Zeile bzw. eine beliebige Spalte in codierter Form gekennzeichnet wird, welche Kennzeichnungen insgesamt als ein erster Vergleichswert für den ersten Komparator ($C_1$) dienen,

- daß der erste Komparator ($C_1$) eine Vielzahl von Vergleichswerteingängen entsprechend Datenausgängen ($Q_1...Q_N$, $Q_{N+1} ...Q_S$) des Zählers (Z) hat, denen ein dem jeweiligen Zählstand des Zählers (Z) entsprechendes Zählstandsdatenwort zugeführt wird,

- daß der zweite Komparator ($C_2$) eine Anzahl von Vergleichswerteingängen entsprechend den Datenausgängen ($Q_1 ...Q_N$) einer ersten Gruppe der Datenausgänge des Zählers (Z) hat, denen die niederwertigen Bits des dem jeweiligen Zählstand entsprechenden Zählstandsdatenwortes zugeführt werden,

- daß dem UND-Glied ($G_1$) gleichfalls diese zuletzt genannten Bits über entsprechend viele Eingänge zugeführt werden,

- daß der erste Komparator ($C_1$) einen Vergleichsausgang ($K_1$) hat, der mit einem von zwei Eingängen des ODER-Gliedes ($G_2$) und einem von zwei Eingängen des NOR-Gliedes ($G_3$) verbunden ist und ein Ausgangssignal gemäß der Bedingung

$$K_1 = \{Q_1 ... QS\} = \{V_1 ... V_S\}$$

abgibt,

- daß der zweite Eingang des ODER-Gliedes ($G_2$) mit dem Rücksetzeingang der Einstell- und Steuereinrichtung (EST) verbunden ist,

- daß der zweite Eingang des NOR-Gliedes (G₃) mit dem Ausgang des UND-
Gliedes (G₁) verbunden ist,

- daß der Rücksetzeingang der Speicheranordnung (SP) mit dem Ausgangssignal des NOR-Gliedes (G₃) beaufschlagt
wird,
- daß ein Rücksetzeingang (R) des Zählers
(Z) mit dem Ausgangssignal des ODER-
Gliedes (G₂) beaufschlagt wird,
- daß ein Vergleichsausgang (K₂) des
zweiten Komparators (C₂) mit dem Steuereingang (ST) des dritten Multiplexers
(D₃) verbunden ist und
- daß der zweite Komparator (C₂) ein Ausgangssignal an den Vergleichsausgang
(K₂) gemäß der Bedingung

$$K_2 = \{Q_1 \ldots Q_N\} \leqq \{V_1 \ldots V_N\}$$

abgibt, in welchem Fall der erste Dateneingang (E₁) des dritten Multiplexers (D₃)
mit dessen Datenausgang (D₀) verbunden ist.

3. Schaltungsanordnung nach Anspruch 1 oder 2,
dadurch **gekennzeichnet**,
- daß entsprechend der Wortbreite der
Eingangsdaten eine Vielzahl von matrixförmigen Speicheranordnungen vorgesehen sind, deren Schreibwort- bzw. Lesewortleitungen parallelgeschaltet und mit
dem gemeinsam für diese matrixförmigen Speicheranordnungen vorgesehenen
Zeilenwähler verbunden sind, und
- daß für jede der matrixförmigen Speicheranordnungen eine Auswahleinrichtung
vorgesehen ist, welche Auswahleinrichtungen mit der gemeinsam für diese
Auswahleinrichtungen vorgesehenen
Einstell- und Steuereinrichtung verbunden sind.

**Claims**

1. Circuit arrangement having a matrix-shaped
memory arrangement (SP) for the variably settable delay of digital signals, the memory arrangement (SP) having a data input (Di) via
which the digital signals to be delayed can be
input, there being provided a row selector
(P₁...Pₙ) which is clock-controlled by an input
data clock, continuously steppable, resettable
at any time and has in each case two signal
outputs per selection step which are offset in
phase relative to one another and which respectively select a write word line or a read
word line which are provided per row of the
matrix, there being provided per column two separate bit lines, to be precise a write bit line
and a read bit line, which are respectively
interconnected with all the memory cells of a
column, there being provided a column a disconnectable storage amplifier (A₁...Aₘ) whose
input is connected to the read bit line of the
column assigned to it and whose output is
connected to the write bit line of the column
following it and serves as a data output assigned to it, the data input of the matrix-
shaped memory arrangement (SP) for the data
signals to be delayed being connected to the
write bit line of the first column and to an
undelayed data output (Z₀), a reset input being
connected to set inputs of a first element (P₁)
of the row selector and to the reset inputs of
the remaining elements (P₂...Pₙ) of the row
selector, there being provided for the purpose
of selecting columns of the memory arrangement (SP) a selector device (AUS) which is
switchable between two selected adjacent columns and to which a portion of an external
delay time setting data word can be supplied
for the selection of these columns, dynamic
switching by means of a supplied control signal (ST) being provided for switching between
the two adjacent columns, a setting and control
device (EST) being provided, which is supplied
with the entire external delay time setting data
word, generates a reset signal ($\overline{RESET}$) for the
memory arrangement (SP) and the control signal (ST) for the selector device (AUS) and
which is supplied with an external reset signal
(RESET) via a reset input, which reset signal is
used to reset the setting and control device
(EST) directly and to reset the memory arrangement (SP) indirectly, the selector device
(AUS) having a data output (D₀) via which the
delayed data signals can be output, the selector device (AUS) being connected by data inputs (E₁...Eₘ) to data outputs (Z₁...Zₘ) of the
memory arrangement (SP), the setting and
control device (EST) being data clock-controlled, and the storage elements being provided as 3-transistor cells having overlapping
write/read cycles.

2. Circuit arrangement according to Claim 1,
characterised in that the selector device (AUS)
comprises an arrangement of a first multiplexer
(D₁), a second multiplexer (D₂) and a third
multiplexer (D₃), data outputs (Z₁...Zₘ) of the
memory arrangement (SP) being respectively
connected offset by one place to data inputs
(E₁...Eₘ) of the first multiplexer (D₁) and to
data inputs (E₂...Eₘ) of the second multiplexer
(D₂), the last data output (Zₘ) of the memory
arrangement (SP) not being connected to one of the data inputs of the second multiplexer $(D_2)$, and the first data input $(E_1)$ of this second multiplexer $(D_2)$ remaining free, in that the two multiplexers $(D_1, D_2)$ are respectively provided with selection inputs $(ST_1...ST_M)$ to which the said portion of the external delay time setting data word is applied and by means of which, in the multiplexers $(D_1, D_2)$, the output (A) thereof can respectively be connected to one of the data inputs (eg $E_2$) in the first multiplexer $(D_1)$ or $(E_2)$ in the second multiplexer $(D_2)$, in that the two outputs (A, A) of the multiplexers $(D_1, D_2)$ are connected to the two single data inputs $(E_1, E_2)$ of the third multiplexer $(D_3)$ whose output (A) represents the data output $(D_0)$ for the delayed input data, and which has a single control input (ST), in that the setting and control device (EST) contains a counter (Z), a first comparator $(C_1)$, a second comparator $(C_2)$, an AND element $(G_1)$, an OR element $(G_2)$ and a NOR element $(G_3)$, in that the counter (Z) has a number of counting steps which corresponds to the number of the memory locations of the memory arrangement (SP), in that the first comparator $(C_1)$ has the function " = ", in that the second comparator $(C_2)$ has the function "≤", in that the setting and control device (EST) has multiplicity of set inputs $(V_1, V_2...V_N, V_{N+1}...V_S)$, for applying the external delay time setting data word, and a reset input (RESET), the set inputs being subdivided into a first group for the low-order bits of the delay time setting data word having the set inputs $(V_1...V_N)$ and into a second group for the high-order bits having the set inputs $(V_{N+1}...V_S)$ in that an arbitrary row of the memory arrangement (SP) is identified in coded form by means of the set inputs $(V_1...V_N)$ of the first group, which identification serves as a first comparison value for the second comparator $(C_2)$, the appertaining rows, or an arbitrary column being identified in coded form by means of the set inputs both of the first and of the second group, which identifications serve overall as a first comparison value for the first comparator $(C_1)$, in that the first comparator $(C_1)$ has a multiplicity of comparison value inputs corresponding to data outputs $(Q_1...Q_N, Q_{N+1}...Q_S)$ of the counter (Z), to which a counter reading data word corresponding to the respective counter reading is supplied, in that the second comparator $(C_2)$ has a number of comparison value inputs corresponding to the data outputs $(Q_1...Q_N)$ of a first group of the data outputs of the counter (Z), to which the low-order bits of the counter reading data word corresponding to the respective counter reading are supplied, in that these last named bits are likewise supplied to the AND element $(G_1)$ via a corresponding number of inputs, in that the first comparator $(C_1)$ has a comparison output $(K_1)$ which is connected to one or two inputs of the OR element $(G_2)$ and to one or two inputs of the NOR elements $(G_3)$ and which emits an output signal in accordance with the condition

$$K_1 = \{Q_1 ... Q_S\} = \{V_1 ... V_S\},$$

in that the second input of the OR element $(G_2)$ is connected to the reset input of the setting and control device (EST), in that the second input of the NOR element $(G_3)$ is connected to the output of the AND element $(G_1)$, in that the output signal of the NOR element $(G_3)$ is applied to the reset input of the memory arrangement (ST), in that the output signal of the OR element $(G_2)$ is applied to a reset input (R) of the counter (Z), in that a comparison output $(K_2)$ of the second comparator $(C_2)$ is connected to the control input (ST) of the third multiplexer $(D_3)$, and in that the second comparator $(C_2)$ emits an output signal to the comparison output $(K_2)$ in accordance with the condition

$$K_2 = \{Q_1 ... Q_N\} \leq \{V_1 ... V_N\},$$

in which case the first data input $(E_1)$ of the third multiplexer $(D_3)$ is connected to the data output $(D_0)$ thereof.

3. Circuit arrangement according to Claim 1 or 2, characterised in that there are provided in accordance with the word widths of the input data a multiplicity of matrix-shaped memory arrangements whose write word lines or read word lines are connected in parallel and are connected to the row selector provided in common for these matrix-shaped memory arrangements, and in that there is provided for each of the matrix-shaped memory arrangements a selector device, which selector devices are connected to the setting and control device provided for these selector devices.

**Revendications**

1. Montage comportant un dispositif de mémoire matriciel (SP) pour appliquer un retard, réglable d'une manière variable, à des signaux numériques, et dans lequel le dispositif de mémoire (SP) possède une entrée de données (Di), au moyen de laquelle les signaux numériques devant être retardés peuvent être introduits, il est prévu un sélecteur de lignes ($P_1...P_N$), qui est commandé de façon cadencée par une cadence des données d'entrée, peut avancer continûment, peut être à tout moment ramené à zéro et comporte, pour chaque pas de sélection, respectivement deux sorties de signaux déphasées réciproquement et qui commandent respectivement une ligne de transmission de mots d'enregistrement et une ligne de transmission de mots de lecture, qui sont prévues pour chaque ligne de la matrice, pour chaque colonne il est prévu deux lignes séparées de transmission de bits, à savoir une ligne de transmission de bits d'enregistrement et une ligne de transmission de bits de lecture, qui sont interconnectées respectivement à toutes les cellules de mémoire d'une colonne, pour chaque colonne il est prévu un amplificateur déconnectable de mémorisation ($A_1...A_m$), dont l'entrée est raccordée à la ligne de transmission de bits de lecture de la colonne qui lui est associée et dont la sortie est raccordée à la ligne de transmission de bits d'enregistrement de la colonne qui est disposée en aval de cet amplificateur, et est utilisée en tant que sortie de données associée à cet amplificateur, et dans lequel

- l'entrée de données du dispositif de mémoire de forme matricielle (SP) est raccordée, pour les signaux de données devant être raccordés, à la ligne de transmission de bits d'enregistrement de la première colonne et une sortie de données non retardées ($Z_\emptyset$),

- une entrée de remise à zéro est raccordée à des entrées de positionnement d'un premier circuit ($P_1$) du sélecteur de lignes ainsi qu'aux entrées de remise à zéro des autres circuits ($P_2...P_N$) du sélecteur de lignes,

- il est prévu un circuit de sélection (AUS), qui sert à sélectionner les colonnes du dispositif de mémoire (SP) et peut être commuté entre deux colonnes voisines sélectionnées et auquel une partie d'un mot externe de données de réglage du retard peut être envoyée pour la sélection de ces colonnes,

- pour la commutation entre les deux colonnes voisines, il est prévu une commutation dynamique au moyen d'un signal de commande envoyé (ST),

- il est prévu un dispositif de réglage et de commande (EST), auquel est envoyé l'ensemble du mot externe de données de réglage du retard, et qui produit un signal de remise à zéro ($\overline{RESET}$) pour le dispositif de mémoire (SP), et le signal de commande (ST) pour le dispositif de sélection (AUS) et auquel un signal externe de remise à zéro (RESET) est envoyé par l'intermédiaire d'une entrée de remise à zéro, qui est utilisé pour ramener à zéro directement le dispositif de réglage et de commande (EST) et indirectement le dispositif de mémoire (SP),

- le dispositif de sélection (AUS) possède une sortie de données ($D_0$) au moyen de laquelle les signaux de données retardés peuvent être délivrés,

- des entrées de données ($E_1...E_M$) du dispositif de sélection (AUS) sont raccordées à des sorties de données ($Z_1...Z_M$) du dispositif de mémoire (SP),

- le dispositif de réglage et de commande (EST) est commandé par la cadence des données, et

- il est prévu, comme éléments de mémoire, des cellules à 3 transistors possédant des cycles d'enregistrement/lecture qui se chevauchent.

2.   Montage suivant la revendication 1, caractérisé par le fait

- que le dispositif de sélection (AUS) est constitué par un ensemble formé d'un premier multiplexeur ($D_1$), d'un second multiplexeur ($D_2$) et d'un troisième multiplexeur ($D_3$), les sorties de données ($Z_1...Z_M$) du dispositif de mémoire (SP) étant raccordées respectivement à des entrées de données ($E_1...E_M$) du premier multiplexeur ($D_1$) et à des entrées de données ($E_2...E_M$) du second multiplexeur ($D_2$) moyennant un décalage d'une position, la dernière sortie de données ($Z_M$) du dispositif de mémoire (SP) n'étant pas raccordée à l'une des entrées de données du second multiplexeur ($D_2$), et la première entrée de données ($E_1$) de ce second multiplexeur ($D_2$) restant libre,

- que pour les deux multiplexeurs ($D_1,D_2$), il est prévu respectivement des entrées de sélection ($ST_1...ST_M$), qui sont chargées par ladite partie du mot externe de données de réglage du retard et à l'aide desquelles, dans les multiplexeurs ($D_1,D_2$), respectivement la sortie (A) de ces multiplexeurs peut être raccordée à l'une des entrées de données (par exemple $E_2$) dans le premier multiplexeur ($D_1$) ou ($E_2$) dans le second multiplexeur ($D_2$),

- que les deux sorties (A,A) des multiplexeurs ($D_1,D_2$) sont raccordées aux

deux entrées uniques de données ($E_1$,$E_2$) du troisième multiplexeur ($D_3$), dont la sortie (A) représente la sortie de données ($D_0$) pour les données retardées d'entrée et qui possède une seule entrée de commande (ST),

- que le dispositif de réglage et de commande (EST) contient un compteur (Z), un premier comparateur ($C_1$), un second comparateur ($C_2$), un circuit ET ($G_1$), un circuit OU ($G_2$) et un circuit NON-OU ($G_3$),

- que le compteur (Z) possède un certain nombre de pas de comptage qui correspond au nombre des emplacements de mémoire du dispositif de mémoire (SP),

- que le premier comparateur ($C_1$) possède la fonction " = ",

- que le second comparateur ($C_2$) possède la fonction "$\leq$",

- que le dispositif de réglage et de commande (EST) possède une multiplicité d'entrées de réglage ($V_1$,$V_2$...$V_N$, $V_{N+1}$...$V_S$) pour l'application du mot externe de données de réglage du retard, et une entrée de remise à zéro (RESET), les entrées de réglage étant réparties en un premier groupe pour les bits de poids inférieur du mot de données de réglage de retard, qui inclut les entrées de réglage ($V_1$...$V_N$), et en un second groupe pour les bits de poids supérieur, qui inclut les entrées de réglage ($V_{N+1}$...$V_S$),

- qu'au moyen des entrées de réglage ($V_1$...$V_N$) du premier groupe, une ligne quelconque du dispositif de mémoire (SP) est caractérisée sous forme codée, laquelle caractérisation étant utilisée en tant que première valeur de comparaison pour le second comparateur ($C_2$), et au moyen des entrées de réglage aussi bien du premier que du second groupe, la ligne concernée ou une colonne quelconque est caractérisée sous forme codée, lesquelles caractérisations sont utilisées globalement en tant que première valeur de comparaison pour le premier conparateur ($C_1$),

- que le premier comparateur ($C_1$) possède une multiplicité de sorties de données ($Q_1$...$Q_N$, $Q_{N+1}$...$Q_S$) du compteur (Z), qui correspondent aux entrées de valeurs de comparaison et auxquelles sont envoyés un mot de données d'état de comptage qui correspond à l'état de comptage respectif du compteur (Z),

- que le second comparateur ($C_2$) possède un certain nombre d'entrées de comparaison, qui correspondent aux sorties de données ($Q_1$...$Q_N$) d'un premier groupe des sorties de données du compteur (Z), auxquelles sont envoyés les bits de poids inférieur du mot de données d'état de comptage qui correspond à l'état de comptage respectif,

- que de même ces bits indiqués en dernier lieu sont envoyés au circuit ET ($G_1$) par l'intermédiaire d'un nombre correspondant d'entrées,

- que le premier comparateur ($C_1$) possède une sortie de comparaison ($K_1$), qui est raccordée à l'une de deux entrées du circuit OU ($G_2$) et à l'une de deux entrées du circuit NON-ET ($G_3$) et délivre un signal de sortie conformément à la relation

$$K_1 = \{Q_1 ... Q_S\} = \{V_1 ... V_S\},$$

- que la seconde entrée du circuit OU ($G_2$) est raccordée à l'entrée de remise à zéro du dispositif de réglage et de commande (EST),

- que la seconde entrée du circuit NON-OU ($G_3$) est raccordée à la sortie du circuit ET ($G_1$),

- que l'entrée de remise à zéro du dispositif de mémoire (SP) est chargée par le signal de sortie du circuit NON-OU ($G_3$),

- qu'une entrée de remise à zéro (R) du compteur (Z) est chargée par le signal de sortie du circuit OU ($G_2$),

- qu'une sortie de comparaison ($K_2$) du second comparateur ($C_2$) est raccordée à l'entrée de commande (ST) du troisième multiplexeur ($D_3$), et

- que le second comparateur ($C_2$) envoie un signal de sortie à la sortie de comparaison ($K_2$) conformément à la condition

$$K_2 = \{Q_1 ... Q_S\} \leq \{V_1 ... V_S\},$$

auquel cas la première entrée de données ($E_1$) du troisième multiplexeur ($D_3$) est raccordée à la sortie de données ($D_0$) de ce multiplexeur.

3. Montage suivant la revendication 1 ou 2, caractérisé par le fait

- qu'en fonction de la largeur du mot des données d'entrée, il est prévu une multiplicité de dispositifs de mémoire sous forme matricielle, dont les lignes de transmission des mots d'enregistrement et des mots de lecture sont branchées en parallèle et sont raccordées au sélecteur de ligne prévu en commun pour ces dispositifs de mémoire sous forme matricielle, et

- que pour chacun des dispositifs de mémoire sous forme matricielle, il est prévu un dispositif de sélection, lesquels dispositifs de sélection sont raccordés au dispositif de réglage et de commande prévu en commun pour ces dispositifs de sélection.

# FIG 1

# FIG 2